(19) Europäisches Patentamt
European Patent Office
Office européen des brevets

(11) **EP 2 216 760 B1**

(12) **EUROPÄISCHE PATENTSCHRIFT**

(45) Veröffentlichungstag und Bekanntmachung des Hinweises auf die Patenterteilung:
**19.10.2016 Patentblatt 2016/42**

(51) Int Cl.:
**G08B 29/18** (2006.01)    **G01R 19/165** (2006.01)
**G01R 31/36** (2006.01)

(21) Anmeldenummer: **09015959.1**

(22) Anmeldetag: **23.12.2009**

(54) **Verfahren und Schaltung zum Überwachen eines Notstromakkumulators einer Gefahrenmeldeanlage**

Method and switch for monitoring an emergency electricity generator of an emergency reporting assembly

Procédé et circuit destinés à surveiller l'accumulateur d'alimentation de secours d'une installation d'avertissement de danger

(84) Benannte Vertragsstaaten:
**AT BE BG CH CY CZ DE DK EE ES FI FR GB GR HR HU IE IS IT LI LT LU LV MC MK MT NL NO PL PT RO SE SI SK SM TR**

(30) Priorität: **29.01.2009 DE 102009006570**

(43) Veröffentlichungstag der Anmeldung:
**11.08.2010 Patentblatt 2010/32**

(73) Patentinhaber: **Novar GmbH**
**41469 Neuss (DE)**

(72) Erfinder:
• **Riemer, Armin**
**41516 Grevenbroich (DE)**

• **Herstix, Frank**
**41466 Neuss (DE)**

(74) Vertreter: **Prietsch, Reiner**
**Henkel, Breuer & Partner**
**Patentanwälte**
**Maximiliansplatz 21**
**80333 München (DE)**

(56) Entgegenhaltungen:
EP-A1- 1 895 312    FR-A1- 2 845 482
US-A- 5 369 364    US-A1- 2002 121 901
US-A1- 2005 035 739    US-A1- 2008 122 614

**Beschreibung**

Die Erfindung betrifft ein Verfahren und eine Schaltung zur Überwachung eines an einen Notstromanschluss einer Gefahrenmeldeanlage ("GMA") angeschlossenen Akkumulators ("Notstromakku" oder nur "Akku").

Bisher wird der Zustand des Notstromakkus z. B. der Zentrale einer Gefahrenmeldeanlage nur durch periodische Spannungsmessung des Akkus überwacht. Hierzu unterbricht das die Zentrale der GMA steuernde Programm kurzzeitig den von einer in die Zentrale integrierten Ladeschaltung gelieferten Ladestrom, der normalerweise nur zur Erhaltungsladung dient. Wenn die dann gemessene Akkuspannung einen Sollwert unterschreitet, wird eine Fehlermeldung erzeugt. In gleicher Weise werden bisher die Notstromakkus von Unterzentralen oder anderen funktionswesentlichen Anlagenteilen einer GMA überwacht.

Nunmehr schreibt die DIN EN 54-4/A2 unter anderem vor, dass zusätzlich zu der Akkuspannung auch der Innenwiderstand von Notstromakkus einer GMA periodisch und bei einem definierten Laststrom auf Überschreitung eines vorgegebenen Höchstwertes überwacht werden muss. Das ist mit einer Zentrale, die eine entsprechend modifizierte Ladeschaltung für den Notstromakku hat, ohne Weiteres möglich.

Sehr aufwendig ist jedoch die Umrüstung einer bereits installierten GMA, deren Zentrale, Unterzentralen usw. nur zur Überwachung der Spannung des betreffenden Notstromakkus eingerichtet sind. Wegen des hohen Integrationsgrades muss im Regelfall nämlich die gesamte Hauptplatine der Zentrale oder des betreffenden anderen Anlagenteiles ausgetauscht werden. Währenddessen ist die GMA naturgemäß nicht funktionsfähig.

Der Erfindung liegt die Aufgabe zugrunde, ein Verfahren und eine Schaltung anzugeben, die es ermöglichen, eine bestehenden Gefahrenmeldeanlage mit geringem Aufwand so umzurüsten, dass auch der Innenwiderstand des jeweiligen Notstromakkus überwacht wird.

Ausgehend von dem bisher üblichen Verfahren zum Überwachen eines an einen Notstromanschluss z. B. der Zentrale einer GMA angeschlossenen Akkumulators ist die genannte Aufgabe dadurch gelöst, dass zwischen den Notstromanschluss und den Akkumulator eine Schaltung eingeschleift wird, die den Innenwiderstand des Akkumulators periodisch prüft und bei einem Wert, der außerhalb eines zulässigen Bereichs liegt, ein Fehlersignal an die Gefahrenmeldeanlage abgibt.

Folglich wird erfindungsgemäß der Innenwiderstand des Akkus mittels einer gesonderten Messschaltung überwacht, die zwischen die zwei Klemmen des Notstromanschlusses der Ladeschaltung der Gefahrenmeldezentrale und die zwei Pole des Akkus eingeschleift wird und die bei Feststellung eines unzulässigen Innenwiderstandes des Akkus eine Fehlermeldung abgibt. Statt also die vorhandene "alte" Ladeschaltung gegen eine zur Messung des Innenwiderstandes des Akkumulators ausgelegte Ladeschaltung austauschen zu müssen, ermöglicht der Vorschlag nach der Erfindung die weitere Benutzung der vorhandenen Ladeschaltung durch Einfügen einer zusätzlichen Schaltung zur Messung des Innenwiderstandes des Akkumulators zwischen den Notstromanschluss der GMA und die Anschlüsse bzw. Pole deren Notstromakkumulators.

Bevorzugt wird als Fehlersignal eine Spannung erzeugt, die kleiner als der Sollwert des Akkumulators ist. In dem betreffenden Betriebszustand reagiert die Ladeschaltung wie bisher auf eine Unterspannung des Akkumulators und erzeugt folglich eine Fehlermeldung, die in üblicher Weise weiter verarbeitet wird, also z.B. in der Zentrale einen optischen und/oder einen akustischen Alarm erzeugt. Folglich ist zur Übermittlung des Fehlersignals von der eingeschleiften Schaltung an die entsprechende Komponente der Gefahrenmeldeanlage keine zusätzliche Signalleitung erforderlich.

Das Fehlersignal kann vielmehr dadurch erzeugt werden, dass die Schaltung den Akkumulator von dem Notstromanschluss trennt oder den Notstromanschluss kurzschließt, so dass in dem entsprechenden Betriebszustand der Ladeschaltung festgestellt wird, dass der Notstromanschluss spannungslos ist.

Zweckmäßig wird mittels der Schaltung der Strom zwischen dem Notstromanschluss und dem Akkumulator nach Betrag und Vorzeichen gemessen und daraus zumindest einer der Betriebszustände der Ladeschaltung ermittelt. Neben den eingangs bereits genannten Betriebszuständen sind somit auch die Betriebzustände "Notstrombetrieb" und "Gefahrenmeldeanlage ausgeschaltet" bzw. "Notstromakkumulator fehlt" ermittelbar.

Bei dem Betriebszustand "Laden des Akkumulators" kann es sich entweder um Erhaltungsladen oder, insbesondere nach einem Notstrombetrieb, um das Laden des teilweise oder vollständig entladenen Akkumulators handeln. Zweckmäßig wird der Innenwiderstand des Akkumulators nur in einem dieser Betriebszustände "Laden des Akkumulators" ermittelt.

Weil die Innenwiderstandsprüfung periodisch durchgeführt wird, jedoch in einem anderen Betriebszustand als "Laden des Akkumulators" ein fehlerhaftes Ergebnis liefern kann, empfiehlt es sich, eine Routine vorzusehen, die die Innenwiderstandsprüfung abbricht, wenn währenddessen ein anderer Betriebszustand als "Laden des Akkumulators" eintritt.

Analog soll das Fehlersignal an die Gefahrenmeldeanlage nur im Betriebszustand "Überwachen der Spannung des Akkumulators" übertragen werden. Hierzu wird das Ergebnis der Prüfung zunächst in der Schaltung abgespeichert.

Jeder Akkumulator hat eine parasitäre Kapazität. Um zu einem korrekten Ergebnis zu kommen, soll deshalb vor dem Prüfen des Innenwiderstandes des Akkumulators dessen parasitäre Kapazität entladen werden.

Ausgehend von einer Schaltung zum Überwachen eines Notstromakkumulators, der an einem Notstromanschluss einer Gefahrenmeldeanlage (GMA) angeschlossen ist, die eine gesteuerte Ladeschaltung mit folgenden Betriebszuständen umfasst:

- Laden dieses Akkumulators (BZ 1, BZ 2),
- periodisches Umschalten auf Überwachung der Spannung des Akkumulators durch Spannungsmessung und Vergleich mit einem Sollwert (BZ 3),
- Erzeugen einer Fehlermeldung wenn die gemessene Spannung einen Sollwert unterschreitet,

wird die oben genannte Aufgabe der Erfindung dadurch gelöst, dass diese Schaltung als Modul zur Einfügung zwischen den zweipoligen Notstromanschluss der Gefahrenmeldeanlage und die Anschlüsse bzw. Pole des Akkumulators ausgebildet ist und periodisch den Innenwiderstand des Akkumulators misst.

In einer bevorzugten Ausführungsform ist bei dieser Schaltung das Bezugspotential ("Minus") durchgeschleift, der GMA-seitige Betriebsspannungsanschluss ("Plus") über einen gesteuerten Trennschalter und einen Strommesswiderstand mit dem akkuseitigen Betriebsspannungsanschluss verbunden, dieser akkuseitige Betriebsspannungsanschluss über einen gesteuerten Lastschalter und einen Lastwiderstand mit dem Bezugspotential verbunden und ein Mikroprozessor vorgesehen, der die GMA-seitige Spannung und die akkuseitige Spannung misst sowie den Trennschalter und den Lastschalter zur Messung des Innenwiderstandes des Akkus steuert, das Messergebnis mit einem gespeicherten Wert vergleicht und in Abhängigkeit von dem Vergleichsergebnis ein Fehlersignal erzeugt. Dabei kann das Messergebnis oder das Vergleichsergebnis oder das Fehlersignal bis zu einem Abruf, insbesondere bis zu dem Zeitpunkt, in dem die Ladeschaltung in den Betriebszustand BZ 3 "Messung der Spannung des Akkumulators und Vergleich mit einem Sollwert" übergeht, zwischengespeichert werden.

Eine Weiterbildung dieser Schaltung zeichnet sich dadurch aus, dass der Mikroprozessor den Betriebszustand der Gefahrenmeldeanlage aus der Spannung der GMA-seitigen Spannung und der akkuseitigen Spannung ermittelt und die Messung des Innenwiderstandes des Akkus nur im Betriebszustand "Laden" oder "Erhaltungsladen" vornimmt sowie bei Eintritt eines anderen Betriebszustandes die Messung abbricht.

Besonders einfach kann die Schaltung den Innenwiderstand des Akkumulators in der Weise ermitteln, dass der Mikroprozessor zur Messung des Innenwiderstandes des Akkus den Trennschalter öffnet, die Leerlaufspannung $U_0$ des Akkus misst, den Lastschalter schließt, die Spannung $U_L$ des mit dem Lastwiderstand belasteten Akkus misst und den Innenwiderstand des

Akkus als $\dfrac{U_0 - U_L}{I_L}$ errechnet, mit

$$I_L = \frac{U_L}{R_L} \ .$$

Um zu vermeiden, dass in Folge der parasitären Kapazität des Akkus ein zu kleiner Innenwiderstand ermittelt wird, soll der Mikroprozessor zumindest die Spannung $U_L$ erst nach Ablauf einer mit dem Schließen des Lastschalters beginnenden Verzögerungszeit messen.

Ein außerhalb eines zulässigen Bereiches liegender Innenwiderstand des Akkumulators ist in der Regel gleichbedeutend mit einem unzulässig starken Absinken der Kapazität des Akkumulators. Damit bei einem Netzausfall gleichwohl noch ein Notstrombetrieb, wenn auch für eine geringere als die spezifizierte Zeit, möglich ist, empfiehlt es sich, den Mikroprozessor so zu programmieren, dass er bei Überschreitung des maximal zulässigen Innenwiderstandes des Akkus den Trennschalter dauerhaft schließt.

Vorzugsweise legt der Mikroprozessor den gemessenen Innenwiderstand oder das Ergebnis dessen Vergleichs mit dem gespeicherten Wert in einem Speicher ab und erzeugt das Fehlersignal nur im Betriebszustand "Spannungsüberwachung des Akkumulators" der Ladeschaltung.

Hierzu genügt es, wenn der Mikroprozessor bei Eintritt dieses Betriebszustandes den Trennschalter öffnet, weil dann die Ladeschaltung eine unzulässige Spannung, nämlich einen spannungslosen Zustand, an dem Notstromanschluss feststellt.

Anhand der Zeichnung wird ein Ausführungsbeispiel der Erfindung beschrieben. Das zeigt:

Figur 1:    ein Blockschaltbild einer Gefahrenmeldeanlage mit einem Batterieüberwachungsmodul,

Figur 2:    ein Blockschaltbild des Batterieüberwachungsmoduls,

Figur 3:    ein Ablaufdiagramm zur Bestimmung des Zustandes eines Notstromakkumulators und

Figur 4:    ein Ablaufdiagramm zur Übermittlung des Akkumulatorzustandes an die Gefahrenmeldeanlage.

Die Zentrale einer Gefahrenmeldeanlage, im Folgenden kurz "GMA" hat ebenso wie etwaige Unterzentralen oder andere Anlagenteile mit eigener Stromversorgung einen Notstromanschluss für einen Notstromakkumulator, im Folgenden kurz "Akku". Dessen Zustand wird gemäß dem Stand der Technik periodisch durch Spannungsmessung im stromlosen Zustand überwacht. Gegenstand der Erfindung ist jedoch die Überwachung des Zustandes des Notstromakkumulators unter einer definierten Last, wie durch die einleitend genannte Norm vorgeschrieben. Dies geschieht durch periodische Messung des Innenwiderstandes des Akkus.

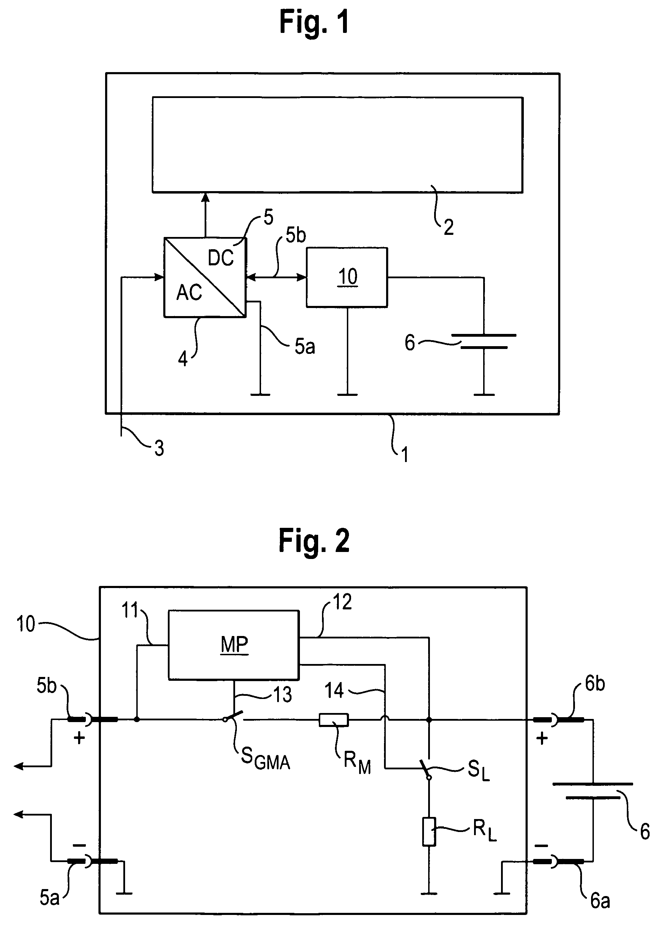

Figur 1 zeigt als Beispiel eine Zentrale 1 einer GMA. Die Zentrale 1 hat eine Steuer- und Auswerteelektronik 2, die normalerweise über einen Netzanschluss 3 und ein Netzgerät 4, bei Ausfall der Spannung am Netzanschluss 3 jedoch aus einem Akku 6 gespeist wird, ebenso wie zumindest ein Teil der Peripherie wie Meldelinien und anderes. Das Netzgerät 4 umfasst eine Ladeschaltung 5 für den Akku 6, dessen Spannung im stromlosen Zustand von der Steuer- und Auswerteelektronik 2 überwacht wird. Die GMA bzw. hier deren Zentrale kann sich hierzu in einem der folgenden Betriebszustände, kurz BZ, befinden:

BZ 1:  Laden des Akkus
BZ 2:  Erhaltungsladen des Akkus
BZ 3:  Spannungsprüfung des Akkus
BZ 4:  Notstrombetrieb
BZ 5:  GMA ausgeschaltet.

Die Betriebszustände, zumindest aber etwaige Fehler, z.B. ein defekter Akku, werden gewöhnlich auf einem (nicht dargestellten) Display angezeigt. In dem stark vereinfachten Blockschaltbild der Figur 1 hat die Ladeschaltung 5 einen Notstromanschluss, nämlich einen auf einem Bezugspotential liegenden Anschluss 5a und einen auf z.B. +12 Volt (Nennwert) liegenden Anschluss 5b. Dieser Notstromanschluss ist nach dem Stand der Technik unmittelbar mit den entsprechenden Polen des Akkus 6 verbunden. Nach dem vorliegenden Vorschlag ist jedoch zwischen diesen Notstromanschluss und den Akku eine Schaltung 10 eingefügt.

Gemäß Figur 2 ist bei der Schaltung 10 der GMA-seitige Bezugspotentialanschluss 5a zu dem entsprechenden Akkupol 6a durchgeschleift. Hingegen ist der Betriebsspannungsanschluss 5b über einen steuerbaren Schalten $S_{GMA}$ und einen Messwiderstand $R_M$ mit dem anderen Akkupol 6b verbunden. Außerdem ist der akkuseitige Betriebsspannungsanschluss über einen gesteuerten Lastschalter $S_L$ in Serie mit einem Lastwiderstand $R_L$ mit dem Bezugspotential verbunden.

Die Schaltung 10 umfasst desweiteren einen Mikroprozessor MP, der neben seinen nicht näher dargestellten Speisespannungsanschlüssen einen Eingang 11 zur Messung der Spannung zwischen den GMA-seitigen Anschlüssen 5a, 5b und einen weiteren Messeingang 12 zur Messung der akkuseitigen Spannung hat. Desweiteren hat der Mikroprozessor MP einen Ausgang 13 zur Steuerung des Trennschalters $S_{GMA}$ und einen Ausgang 14 zur Steuerung des Lastschalters $S_L$. Bei geschlossenem Trennschalter $S_{GMA}$ ermittelt der Mikroprozessor aus dem Spannungsabfall über dem Strommesswiderstand $R_M$ und dessen Widerstandswert den Strom (Lade- oder Entladestrom) nach Betrag und Vorzeichen.

Zur Ermittlung des Innenwiderstandes $R_i$ des Akkus 6 öffnet der Mikroprozessor MP den Trennschalter $S_{GMA}$ in periodischen Zeitabständen für ein kurzes Zeitintervall, misst über den Eingang 12 die sich dann einstellende Leerlaufspannung $U_0$ des Akkus 6, schließt dann den Lastschalter $S_L$ und misst erneut die dann niedrigere Spannung $U_L$ des Akkus 6. Diese Messungen kann der Mikroprozessor MP auch in umgekehrter Reihenfolge durchführen. Eine Zeitverzögerungsschaltung in dem Mikroprozessor MP sorgt dafür, dass zumindest die Spannungsmessung nach dem Schließen des Lastschalters $S_L$ erst dann durchgeführt wird, wenn sich die parasitäre Kapazität des Akkus 6 über $R_L$ entladen hat. Eine kurze Verzögerungszeit zwischen dem Öffnen von $S_{GMA}$ und der Messung von $U_0$ ist jedoch aus dem gleichen Grund empfehlenswert, weil insbesondere bei einem großen Ladestrom unmittelbar nach dem Öffnen von $S_{GMA}$ ein zu hoher Wert von $U_0$ gemessen wird.

Aus den gemessenen Werten errechnet der Mikroprozessor den Innenwiderstand des Akkus nach der Beziehung $$R_i = \frac{U_0 - U_L}{I_L}, \quad \text{mit}$$

$$I_L = \frac{U_L}{R_L}.$$

Im Übrigen kann $R_i$ auch auf andere, dem Fachmann bekannte Art ermittelt werden.

Der Mikroprozessor MP ist so programmiert, dass er die genannten Messungen nur durchführt, wenn bis zum Ende der zweiten Messung entweder BZ 1 oder BZ 2 vorliegt. Der errechnete Wert von $R_i$ wird mit einem gespeicherten Wert verglichen. Liegt der gemessene Wert und damit das Vergleichsergebnis außerhalb eines ebenfalls gespeicherten Toleranzbereiches, so wird das Vergleichsergebnis als Fehler gespeichert. Bei der nächsten periodischen Spannungsprüfung durch die Ladeschaltung, das heißt beim Eintritt des nächsten Betriebszustandes BZ 3, den der Mikroprozessor MP daran erkennt, dass der Spannungsabfall über $R_M$ gleich 0 wird, öffnet der Mikroprozessor dann den Trennschalter $S_{GMA}$, so dass die Ladeschaltung oder die Steuer- und Auswerteelektronik der GMA diesen Zustand erkennt und zu einer Fehlermeldung verarbeitet.

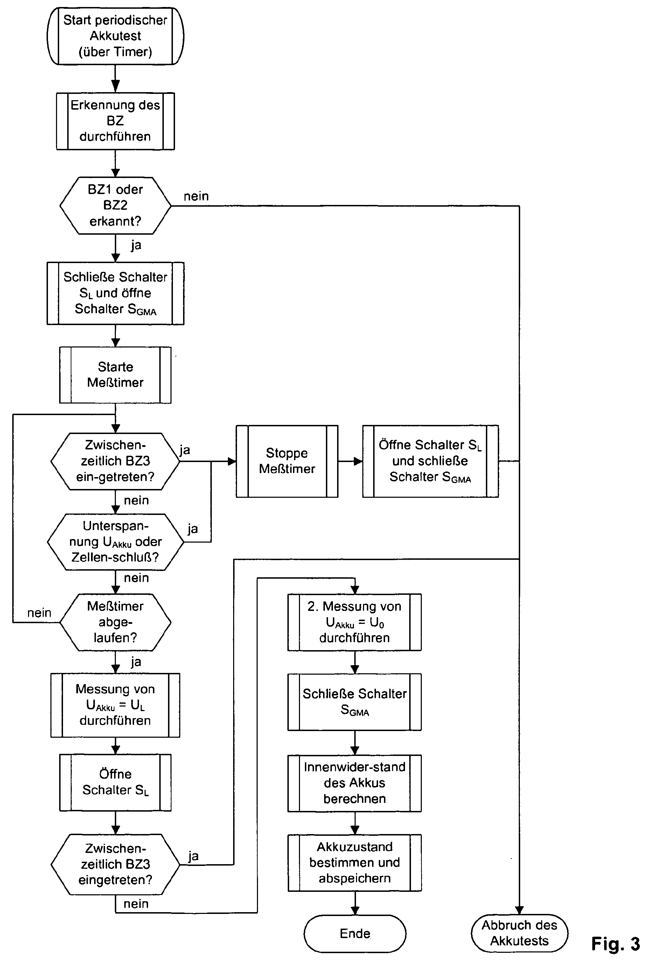

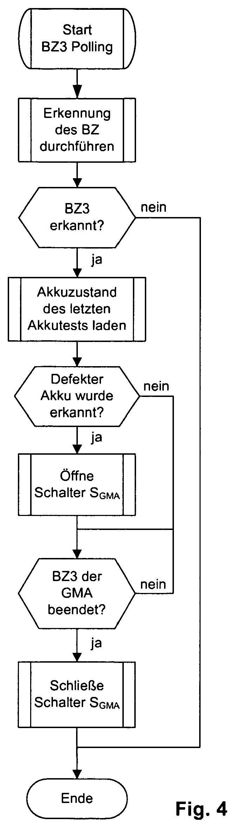

Im Einzelnen ist das Programm des Mikroprozessors zur Bestimmung des Innenwiderstandes des Akkus in dem Ablaufdiagramm der Figur 3 und das Programm zur Feststellung eines fehlerhaften Akkus durch die Ladeschaltung oder die Steuer- und Auswerteelektronik der GMA in Figur 4 dargestellt.

Aus Figur 3 ist ersichtlich, dass die Schaltung 10, genauer gesagt deren Mikroprozessor MP ohne schaltungstechnischen Mehraufwand auch die Zustände des Akkus "Unterspannung" und/ oder "Zellenschluss" feststellen kann. Diese Fehlerzustände können ebenfalls gespeichert und gegebenenfalls von der GMA abgefragt werden (nicht dargestellt), lösen aber zumindest das Schließen des Trennschalters $S_{GMA}$ und den Abbruch des Messablaufs aus.

**Patentansprüche**

1. Verfahren zum Überwachen eines Notstromakkumulators, der an einen Notstromanschluss einer Gefahrenmeldeanlage (GMA) angeschlossen ist, die eine gesteuerte Ladeschaltung mit folgenden Betriebszuständen umfasst:

    - Laden dieses Akkumulators (BZ 1, BZ 2),
    - periodisches Umschalten auf Überwachung der Spannung des Akkumulators durch Spannungsmessung und Vergleich mit einem Sollwert (BZ 3),
    - Erzeugen einer Fehlermeldung wenn die gemessene Spannung einen Sollwert unterschreitet,

    **dadurch gekennzeichnet, dass**
    zwischen den Notstromanschluss und den Akkumulator eine Schaltung eingeschleift wird, die den Innenwiderstand (Ri) des Akkumulators periodisch prüft und bei einem Wert, der außerhalb eines zulässigen Bereichs liegt, ein Fehlersignal an die Gefahrenmeldeanlage abgibt wobei das Fehlersignal dadurch erzeugt wird, dass
    die Schaltung den Akkumulator von dem Notstromanschluss trennt oder den Notstromanschluss kurzschließt, so dass bei der Überwachung der Spannung des Akkumulators durch Spannungsmessung durch die Ladeschaltung festgestellt wird, dass der Notstromanschluss spannungslos ist.

2. Verfahren nach Anspruch 1, **dadurch gekennzeichnet, dass** das Fehlersignal dadurch erzeugt wird, dass der Akkumulator mittels der Schaltung von dem Notstromanschluss getrennt wird.

3. Verfahren nach Anspruch 1, **dadurch gekennzeichnet, dass** das Fehlersignal dadurch erzeugt wird, dass die Schaltung den Notstromanschluss kurzschließt.

4. Verfahren nach einem der Ansprüche 1 bis 3, **dadurch gekennzeichnet, dass** mittels der Schaltung der Strom zwischen dem Notstromanschluss und dem Akkumulator nach Betrag und Vorzeichen gemessen und daraus zumindest einer der Betriebszustände der Ladeschaltung ermittelt wird.

5. Verfahren nach einem der Ansprüche 1 bis 4, **dadurch gekennzeichnet, dass** zumindest die Betriebszustände BZ 1, BZ 2 "Laden des Akkumulators" ermittelt werden und nur in einem dieser Betriebszustände der Innenwiderstand des Akkumulators geprüft wird.

6. Verfahren nach einem der Ansprüche 1 bis 5, **dadurch gekennzeichnet, dass** die Innenwiderstandsprüfung abgebrochen wird, wenn ein anderer Betriebszustand als "Laden des Akkumulators" vorliegt.

7. Verfahren nach einem der Ansprüche 1 bis 6, **dadurch gekennzeichnet, dass** das Fehlersignal an die Gefahrenmeldeanlage nur im Betriebszustand BZ 3 "Überwachen der Spannung des Akkumulators" übertragen wird.

8. Verfahren nach einem der Ansprüche 1 bis 7, **dadurch gekennzeichnet, dass** vor dem Prüfen des Innenwiderstandes des Akkumulators dessen parasitäre Kapazität entladen wird.

9. Schaltung zum Überwachen eines Notstromakkumulators, der an einem Notstromanschluss einer Gefahrenmeldeanlage (GMA) angeschlossen ist, die eine gesteuerte Ladeschaltung aufweist, diese Ladeschaltung ist so ausgebildet, dass sie die folgenden Betriebszuständen umfasst:

    - Laden dieses Akkumulators (BZ 1, BZ 2),
    - periodisches Umschalten auf Überwachung der Spannung des Akkumulators durch Spannungsmessung und Vergleich mit einem Sollwert (BZ 3),
    - Erzeugen einer Fehlermeldung wenn die gemessene Spannung einen Sollwert unterschreitet, insbesondere zur Durchführung des Verfahrens nach einem der Ansprüche 1 bis 9,

    **dadurch gekennzeichnet, dass**
    sie als Modul zur Einfügung zwischen den zweipoligen Notstromanschluss der GMA und die Anschlüsse des Akkumulators ausgebildet ist und periodisch den Innenwiderstand (Ri) des Akkumulators misst und ein Fehlersignal abgibt , wobei durch das Fehlersignal die Schaltung ausgestaltet ist, um den Akkumulator von dem Notstromanschluss zu trennen oder den Notstromanschluss kurzschließen, so dass in dem entsprechenden Betriebszustand der Ladeschaltung festgestellt wird, dass der Notstromanschluss spannungslos ist.

10. Schaltung nach Anspruch 9, **dadurch gekennzeichnet, dass** das Bezugspotential ("Minus") durchgeschleift ist, dass der GMA-seitige Betriebsspannungsanschluss ("Plus") über einen gesteuerten Trennschalter ($S_{GMA}$) und einen Strommesswiderstand ($R_M$) mit dem akkuseitigen Betriebsspannungsanschluss verbunden ist, dass der akkuseitige Betriebsspannungsanschluss über einen gesteuerten Lastschalter ($S_L$) und einen Lastwiderstand ($R_L$) mit dem Bezugspotential verbunden ist, und dass ein Mikroprozessor (MP) die GMA-seitige Spannung und die akkuseitige Spannung misst sowie den Trennschalter ($S_{GMA}$) und den Lastschalter ($S_L$) zur

Messung des Innenwiderstandes ($R_i$) des Akkus steuert, das Messergebnis mit einem gespeicherten Wert vergleicht und in Abhängigkeit von dem Vergleichsergebnis ein Fehlersignal erzeugt.

11. Schaltung nach Anspruch 10, **dadurch gekennzeichnet, dass** der Mikroprozessor (MP) den Betriebszustand der GMA aus der Messung der GMA-seitigen Spannung und der akkuseitigen Spannung ermittelt und die Messung des Innenwiderstandes (Ri) des Akkus nur im Betriebszustand "Laden" oder "Erhaltungsladen" (BZ 1, BZ 2) vornimmt sowie bei Eintritt eines anderen Betriebszustandes die Messung abbricht.

12. Schaltung nach Anspruch 10 oder 11, **dadurch gekennzeichnet, dass** der Mikroprozessor (MP) zur Messung des Innenwiderstandes ($R_i$) des Akkus den Trennschalter (SGMA) öffnet, die Leerlaufspannung $U_0$ des Akkus misst, den Lastschalter ($S_L$) schließt, die Spannung $U_L$ des mit dem Lastwiderstand ($R_L$) belasteten Akkus misst und den Innenwiderstand ($R_i$) des Akkus als

$$\frac{U0 - Ul}{IL} \; errechnet, mit \; IL = \frac{UL}{RL}$$

13. Schaltung nach Anspruch 12, **dadurch gekennzeichnet, dass** der Mikroprozessor (MP) die Spannung $U_L$ erst nach Ablauf einer mit dem Schließen des Lastschalters (SL) beginnenden Verzögerungszeit misst.

14. Schaltung nach einem der Ansprüche 9 bis 13, **dadurch gekennzeichnet, dass** der Mikroprozessor (MP) bei Überschreitung des maximal zulässigen Innenwiderstandes ($R_i$) des Akkus den Trennschalter ($S_{GMA}$) dauerhaft schließt.

15. Schaltung nach einem der Ansprüche 9 bis 14, **dadurch gekennzeichnet, dass** der Mikroprozessor (MP) den gemessenen Innenwiderstand ($R_i$) des Akkus oder das Ergebnis des Vergleichs mit dem gespeicherten Wert in einem Speicher ablegt und das Fehlersignal nur im Betriebszustand BZ 3 der GMA erzeugt.

16. Schaltung nach Anspruch 15, **dadurch gekennzeichnet, dass** der Mikroprozessor (MP) das Fehlersignal durch Öffnen des Trennschalters ($S_{GMA}$) im Betriebszustand BZ 3 erzeugt.

## Claims

1. Method for monitoring an emergency power accumulator connected to an emergency power connection of a warning system (WS), which comprises a controlled charging circuit having the following operating states:

- charging said accumulator (BZ 1, BZ 2)
- periodically switching to monitoring the voltage of the accumulator by measuring the voltage and comparing it with a threshold value (BZ 3),
- generating an error message when the voltage measured falls below a threshold value,

**characterised in that**
a circuit is looped in between the emergency power connection and the accumulator, periodically tests the internal resistance ($R_i$) of the accumulator and delivers an error signal to the warning system when a value is outside a permissible range, the error signal being generated by the circuit disconnecting the accumulator from the emergency power connection or short-circuiting the emergency power connection such that, when monitoring the voltage of the accumulator by measuring the voltage by means of the charging circuit, it is established that the emergency power connection is de-energised.

2. Method according to claim 1, **characterised in that** the error signal is generated by the accumulator being disconnected from the emergency power connection by means of the circuit.

3. Method according to claim 1, **characterised in that** the error signal is generated by the circuit short-circuiting the emergency power connection.

4. Method according to any of claims 1 to 3, **characterised in that** the circuit measures the magnitude and polarity of the voltage between the emergency power connection and the accumulator and at least one of the operating states of the charging circuit is determined therefrom.

5. Method according to any of claims 1 to 4, **characterised in that** at least the operating states BZ 1 and BZ 2 "charging the accumulator" are determined, and the internal resistance of the accumulator is only tested in one of these operating states.

6. Method according to any of claims 1 to 5, **characterised in that** testing of the internal resistance is stopped in any operating state other than "charging the accumulator".

7. Method according to any of claims 1 to 6, **characterised in that** the error signal is only transmitted to the warning system in the operating state BZ 3, "monitoring the voltage of the accumulator".

8. Method according to any of claims 1 to 7, **charac-**

**terised in that** the parasitic capacitance of the accumulator is discharged prior to testing the internal resistance thereof.

9. Circuit for monitoring an emergency power accumulator connected to an emergency power connection of a warning system (WS), comprising a controlled charging circuit, said charging circuit being designed so as to have the following operating states:

- charging said accumulator (BZ 1, BZ 2),
- periodically switching to monitoring the voltage of the accumulator by measuring the voltage and comparing it with a threshold value (BZ 3),
- generating an error message when the voltage measured falls below a threshold value, in particular in order to carry out the method according to any of claims 1 to 9,

**characterised in that**
said circuit is formed as a module for insertion between the two-pole emergency power connection of the WS and the connections of the accumulator, and periodically measures the internal resistance (Ri) of the accumulator and emits an error signal, the circuit being designed to disconnect the accumulator from the emergency power connection or to short-circuit the emergency power connection as a result of the error signal so that in the corresponding operating state of the charging circuit it is established that the emergency power connection is de-energised.

10. Circuit according to claim 9, **characterised in that** the reference potential ("minus") is looped through, **in that** the WS-side operating voltage connection ("plus") is connected to the accumulator-side operating voltage connection by means of a controlled disconnecting switch ($S_{WS}$) and a power precision resistor ($R_m$), **in that** the accumulator-side operating voltage connection is connected to the reference potential by means of a controlled load switch ($S_L$) and a load resistor ($R_L$), and **in that** a microprocessor (MP) measures the WS-side voltage and the accumulator-side voltage and controls the disconnecting switch ($S_{WS}$) and the load switch ($S_L$) in order to measure the internal resistance ($R_i$) of the accumulator, compares the measurement result with a stored value and generates an error signal on the basis of the result of the comparison.

11. Circuit according to claim 10, **characterised in that** the microprocessor (MP) determines the operating state of the WS from the measurement of the WS-side voltage and the accumulator-side voltage, and the internal resistance ($R_i$) of the accumulator is only measured in the operating state "charging" or "float charging" (BZ 1, BZ 2) and measurement is stopped when a different operating state is entered.

12. Circuit according to either claim 10 or claim 11, **characterised in that**, in order to measure the internal resistance ($R_i$) of the accumulator, the microprocessor (MP) opens the disconnecting switch (SGMA), measures the open-circuit voltage $U_0$ of the accumulator, closes the load switch ($S_L$), measures the voltage $U_L$ of the accumulator loaded with the load resistance ($R_L$) and calculates the internal resistance ($R_i$) of the accumulator as

$$\frac{U0 - Ul}{Il}, \qquad where\ IL = \frac{UL}{RL}$$

13. Circuit according to claim 12, **characterised in that** the microprocessor (MP) measures the voltage $U_L$ only after a delay time has elapsed, which starts when the load switch (SL) is closed.

14. Circuit according to any of claims 9 to 13, **characterised in that** the microprocessor (MP) permanently closes the disconnecting switch ($S_{WS}$) when the maximum permissible internal resistance ($R_i$) of the accumulator is exceeded.

15. Circuit according to any of claims 9 to 14, **characterised in that** the microprocessor (MP) stores the measured internal resistance ($R_i$) of the accumulator or the result of the comparison thereof with the stored value in a memory and only generates the error signal in the operating state BZ 3 of the WS.

16. Circuit according to claim 15, **characterised in that** the microprocessor (MP) generates the error signal by opening the disconnecting switch ($S_{WS}$) in the operating state BZ 3.

**Revendications**

1. Procédé de surveillance d'un accumulateur d'alimentation de secours qui est raccordé à un raccord d'alimentation de secours d'une installation d'avertissement de danger (GMA) qui comporte un circuit de charge commandé avec les états de fonctionnement suivants :

- chargement de cet accumulateur (BZ 1, BZ 2),
- commutation périodique sur la surveillance de la tension de l'accumulateur par mesure de tension et comparaison avec une valeur de consigne (BZ 3),
- génération d'un message d'erreur lorsque la tension mesurée n'atteint pas une valeur de consigne,

**caractérisé en ce que**
un circuit est inséré entre le raccord d'alimentation de secours et l'accumulateur, lequel vérifie périodiquement la résistance intérieure ($R_i$) de l'accumulateur et en cas de valeur qui se trouve en dehors d'une plage autorisée, émet un signal d'erreur à l'attention de l'installation d'avertissement de danger, le signal d'erreur étant généré du fait que
le circuit sépare l'accumulateur du raccord d'alimentation de secours ou court-circuite le raccord d'alimentation de secours de sorte que lors de la surveillance de la tension de l'accumulateur par le circuit de charge, il soit constaté que le raccord d'alimentation de secours est sans tension.

2. Procédé selon la revendication 1, **caractérisé en ce que** le signal d'erreur est généré du fait que l'accumulateur est séparé du raccord d'alimentation de secours à l'aide du circuit.

3. Procédé selon la revendication 1, **caractérisé en ce que** le signal d'erreur est généré du fait que le circuit court-circuite le raccord de d'alimentation de secours.

4. Procédé selon l'une quelconque des revendications 1 à 3, **caractérisé en ce qu'**à l'aide du circuit, le courant entre le raccord d'alimentation de secours et l'accumulateur est mesuré selon la quantité et le signe et au moins l'un des états de fonctionnement du circuit de charge est déterminé à partir de cela.

5. Procédé selon l'une quelconque des revendications 1 à 4, **caractérisé en ce qu'**au moins les états de fonctionnement BZ 1, BZ 2 « charge de l'accumulateur » sont déterminés et seulement dans un de ces états de fonctionnement, la résistance intérieure de l'accumulateur est vérifiée.

6. Procédé selon l'une quelconque des revendications 1 à 5, **caractérisé en ce que** la vérification de la résistance intérieure est interrompue lorsqu'un autre état de fonctionnement que « charge de l'accumulateur » se présente.

7. Procédé selon l'une quelconque des revendications 1 à 6, **caractérisé en ce que** le signal d'erreur est transmis à l'installation d'avertissement de danger seulement dans l'état de fonctionnement BZ 3 « surveillance de la tension de l'accumulateur ».

8. Procédé selon l'une quelconque des revendications 1 à 7, **caractérisé en ce que** la capacité parasitaire de l'accumulateur est déchargée avant la vérification de sa résistance intérieure.

9. Circuit de surveillance d'un accumulateur d'alimentation de secours qui est raccordé à un raccord d'alimentation de secours d'une installation de signalisation de danger (GMA) qui présente un circuit de charge commandé, ce circuit de charge est réalisé de sorte qu'il comporte les états de fonctionnement suivants :

- charge de cet accumulateur (BZ 1, BZ 2),
- commutation périodique sur la surveillance de la tension de l'accumulateur par mesure de tension et comparaison avec une valeur de consigne (BZ 3),
- génération d'un message d'erreur lorsque la tension mesurée n'atteint pas une valeur de consigne en particulier pour la réalisation du procédé selon l'une quelconque des revendications 1 à 9, **caractérisé en ce que**

il est réalisé comme module pour l'insertion entre le raccord d'alimentation de secours à deux pôles de la GMA et les raccords de l'accumulateur et mesure périodiquement la résistance intérieure (Ri) de l'accumulateur et émet un signal d'erreur, le circuit étant configuré par le signal d'erreur afin de séparer l'accumulateur du raccord d'alimentation de secours ou de court-circuiter le raccord d'alimentation de secours de sorte que dans l'état de fonctionnement correspondant du circuit de charge, il soit constaté que le raccord d'alimentation de secours est sans tension.

10. Circuit selon la revendication 9, **caractérisé en ce que** le potentiel de référence (« moins ») est bouclé, **en ce que** le raccord de tension de fonctionnement (« plus ») côté GMA est relié par un sectionneur ($S_{GMA}$) commandé et une résistance de mesure de commande ($R_M$) au raccord de tension de fonctionnement côté accumulateur, **en ce que** le raccord de tension de fonctionnement côté accumulateur est relié par un commutateur de charge ($S_L$) commandé et une résistance de charge ($R_L$) au potentiel de référence, et **en ce qu'**un microprocesseur (MP) mesure la tension côté GMA et la tension côté accumulateur ainsi que le sectionneur ($S_{GMA}$) et le commutateur de charge ($S_L$) pour la mesure de la résistance intérieure ($R_i$) de l'accumulateur, compare le résultat de mesure avec une valeur enregistrée et génère un signal d'erreur en fonction du résultat de comparaison.

11. Circuit selon la revendication 10, **caractérisé en ce que** le microprocesseur (MP) détermine l'état de fonctionnement de la GMA à partir de la mesure de la tension côté GMA et la tension côté accumulateur et entreprend la mesure de la résistance intérieure ($R_i$) de l'accumulateur seulement dans l'état de fonctionnement « charge » ou « charge de maintien » (BZ 1, BZ 2) ainsi qu'interrompt la mesure en cas d'entrée d'un autre état de fonctionnement.

12. Circuit selon la revendication 10 ou 11, **caractérisé**

**en ce que** le microprocesseur (MP) ouvre pour la mesure de la résistance intérieure ($R_i$) de l'accumulateur le sectionneur (SGMA), mesure la tension de marche à vide $U_0$ de l'accumulateur, ferme le commutateur de charge ($S_L$), mesure la tension $U_L$ de l'accumulateur chargé avec la résistance de charge ($R_L$) et calcule la résistance intérieure ($R_i$) de l'accumulateur comme

$$\frac{U0 - Ul}{IL} \text{ avec } \mathtt{IL} = \frac{UL}{RL}$$

**13.** Circuit selon la revendication 12, **caractérisé en ce que** le microprocesseur (MP) ne mesure la tension $U_L$ qu'après expiration d'un temps de retard commençant par la fermeture du commutateur de charge (SL).

**14.** Circuit selon l'une quelconque des revendications 9 à 13, **caractérisé en ce que** le microprocesseur (MP) ferme durablement le sectionneur ($S_{GMA}$) en cas de dépassement de la résistance intérieure ($R_i$) autorisée au maximum de l'accumulateur.

**15.** Circuit selon l'une quelconque des revendications 9 à 14, **caractérisé en ce que** le microprocesseur (MP) enregistre la résistance intérieure ($R_i$) mesurée de l'accumulateur ou le résultat de la comparaison avec la valeur enregistrée dans une mémoire et génère le signal d'erreur seulement dans l'état de fonctionnement BZ 3 ou GMA.

**16.** Circuit selon la revendication 15, **caractérisé en ce que** le microprocesseur (MP) génère le signal d'erreur par ouverture du sectionneur ($S_{GMA}$) dans l'état de fonctionnement BZ 3.

EP 2 216 760 B1

# Fig. 1

# Fig. 2

Fig. 3

Fig. 4